# EUROPÄISCHE PATENTSCHRIFT

(11) **EP 4 222 470 B1**
(45) Veröffentlichungstag und Bekanntmachung des Hinweises auf die Patenterteilung: **14.05.2025**
(21) Anmeldenummer: 21800978.5
(22) Anmeldetag: 01.10.2021
(51) Int. Cl.: G01M 15/02, G06N 3/02, G09B 9/042, G06Q 10/04, F02D 29/02, G08G 1/01, G01M 17/06, G06N 3/08, G06N 7/01, G06Q 50/40

(54) **COMPUTERGESTÜTZTES VERFAHREN UND VORRICHTUNG ZUR WAHRSCHEINLICHKEITSBASIERTEN GESCHWINDIGKEITSPROGNOSE FÜR FAHRZEUGE**
COMPUTER-BASED METHOD AND DEVICE FOR PROBABILITY-BASED SPEED PREDICTION IN VEHICLES
PROCEDE ET DISPOSITIF INFORMATIQUES POUR LA PREDICTION DE VITESSE BASEE SUR LA PROBABILITE POUR DES VEHICULES

(30) Priorität: 02.10.2020 AT 508472020
(43) Veröffentlichungstag der Anmeldung: 09.08.2023
(73) Patentinhaber: AVL List GmbH, 8020 Graz (AT)
(72) Erfinder: DIDCOCK, Nico, 8020 Graz (AT); WASSERBURGER, Alexander, 1120 Wien (AT); HAMETNER, Christoph, 1020 Wien (AT); MAYR, Christian, 3493 Hadersdorf am Kamp (AT)
(74) Vertreter: Hahner, Ralph
(86) Internationale Anmeldenummer: PCT/AT2021/060355
(87) Internationale Veröffentlichungsnummer: WO 2022/067368

(56) Entgegenhaltungen:
- EP-A1- 3 540 403
- TAE-KYUNG LEE ET AL: "Synthesis of Real-World Driving Cycles and Their Use for Estimating PHEV Energy Consumption and Charging Opportunities: Case Study for Midwest/U.S", IEEE TRANSACTIONS ON VEHICULAR TECHNOLOGY, IEEE, USA, vol. 60, no. 9, 1 November 2011 (2011-11-01), pages 4153 - 4163, XP011388454, ISSN: 0018-9545, DOI: 10.1109/TVT.2011.2168251
- DIETRICH MAXIMILIAN ET AL: "A Combined Markov Chain and Reinforcement Learning Approach for Powertrain-Specific Driving Cycle Generation", SAE INTERNATIONAL JOURNAL OF ADVANCES AND CURRENT PRACTICES IN MOBILITY, vol. 3, no. 1, 15 September 2020 (2020-09-15), pages 516 - 527, XP055875895, ISSN: 2641-9645, Retrieved from the Internet <URL:http://dx.doi.org/10.4271/2020-01-2185> DOI: 10.4271/2020-01-2185

## Beschreibung

Die Erfindung betrifft ein computergestütztes Verfahren und eine Vorrichtung zum Erzeugen eines Fahrzyklus für ein Fahrzeug, welches sich zur Simulation eines Fahrbetriebs, insbesondere eines realen Fahrbetriebs, eignet.

Emissionsrichtlinien für Fahrzeuge mit Verbrennungsmotoren sind fortwährenden Veränderungen unterworfen, welche das Ziel haben, Fahrverhältnisse zu berücksichtigen, die realen Fahrverhältnissen auf der Straße zunehmend näher kommen. Ein Beispiel für solche Emissionsrichtlinien ist die Regulierung von Testverfahren durch die Europäische Union, um Emissionen von Fahrzeugen unter realen Fahrbedingungen, sog. Real Driving Emissions (RDE), zu bestimmen. Diese Testverfahren sind beispielsweise Teil des Zulassungsverfahrens von Fahrzeugtypen. Emissionstests können demnach nicht mehr ausschließlich an einem Fahrzeugteststand mit allgemein definierten Fahrzyklen durchgeführt werden, sondern müssen unter realen Fahrbedingungen erfolgen, um beispielsweise den Einfluss von realen Verkehrsverhältnissen und dem realen Fahrverhalten eines Fahrers zu berücksichtigen.

So müssen beispielsweise Fahrstrecken unterschiedlicher Geschwindigkeitsbereiche und minimale bzw. maximale Haltezeiten in einem RDE-konformen Fahrzyklus enthalten sein, welcher als Grundlage für eine richtlinienkonforme Emissionsbestimmung dient. Emissionsrichtlinien mit dem Ziel, reale Fahrverhältnisse auf der Straße zu berücksichtigen, lassen jedoch eine Vielzahl von unterschiedlichen Fahrzyklen zu, was für Fahrzeughersteller bei der Fahrzeugentwicklung einen enormen Testaufwand mit sich bringt. Um den Verbrauch eines Fahrzeugs unter realen Fahrbedingungen bestimmen zu können, wird der Verbrauch typischerweise für ca. 1000 RDE-konforme Fahrzyklen bestimmt. Dieser Testaufwand kann durch die Simulation einer Vielzahl von unterschiedlichen, richtlinienkonformen Fahrzyklen, welche realistisches Fahrverhalten berücksichtigen, reduziert werden.

Um solche Fahrzyklen zu erstellen, können Fahrzyklen unter Verwendung von Markov-Ketten oder neuronalen Netzwerken simuliert werden. Die so generierten Fahrzyklen zeigen jedoch erhebliche Abweichungen von Fahrzyklen, welche unter realen Bedingungen auf der Straße gemessen werden. Alternativ können kurze Fahrstrecken, welche unter realen Bedingungen auf der Straße gemessen wurden, auf unterschiedliche Weise miteinander kombiniert werden, um einen Fahrzyklus zu generieren. Auf diese Weise erzeugte Fahrzyklen sind sich untereinander jedoch relativ ähnlich und bieten somit nur eine unzureichende Variabilität, um einen realen, durchschnittlichen Fahrzeugverbrauch zu bestimmen. Für die Erfindung relevante Dokumente aus dem Stand der Technik sind die folgenden Dokumente:
- Tae-Kyung Lee et al., "Synthesis of Real-World Driving Cycles and Their Use for Estimating PHEV Energy Consumption and Charging Opportunities: Case Study for Midwest/U.S", IEEE Transactions on Vehicular Technology, IEEE, USA, Bd. 60, Nr. 9, 1. November 2011, Seiten 4153-4163, DOI: 10.1109/TVT.2011.2168251;
- Dietrich Maximilian et al., "A Combined Markov Chain and Reinforcement Learning Approach for Powertrain-Specific Driving Cycle Generation", SAE International Journal of Advances and Current Practices in Mobility, Bd. 3, Nr. 1, 15. September 2020, Seiten 516-527, DOI: 10.4271/2020-01-2185.

Es ist eine Aufgabe der vorliegenden Erfindung, eine Vielzahl voneinander verschiedener Fahrzyklen, welche realem Fahrverhalten eines Fahrzeugs entsprechen, zu generieren.

Diese Aufgabe wird gelöst durch ein computergestütztes Verfahren und eine Vorrichtung gemäß den unabhängigen Ansprüchen. Bevorzugte Ausführungsformen werden in den Unteransprüchen beansprucht.

Ein erster Aspekt der Erfindung betrifft ein computergestütztes Verfahren zum Erzeugen eines Fahrzyklus für ein Fahrzeug, welches sich zur Simulation eines, insbesondere realen, Fahrbetriebs eignet. Das computergestützte Verfahren weist ein Ermitteln eines Zustandsvektors des Fahrzyklus für ein aktuelles Zeitintervall aus einem Geschwindigkeitsverlauf der Vergangenheit, ein Bereitstellen eines Beschleunigungsprognosemodells, ein Bestimmen eines Beschleunigungswerts unter Berücksichtigung von Wahrscheinlichkeiten, welche sich aus dem Beschleunigungsprognosemodell und dem Zustandsvektor ergeben, ein Integrieren des bestimmten Beschleunigungswerts über das aktuelle Zeitintervall, um einen vorhergesagten Geschwindigkeitswert für ein nächstes Zeitintervall in der Zukunft zu erhalten und ein Anhängen des vorhergesagten Geschwindigkeitswerts an den Geschwindigkeitsverlauf der Vergangenheit zum Erzeugen des Fahrzyklus auf.

Ein Fahrzyklus im Sinne der Erfindung ist insbesondere ein Zeitintervall, welchem ein konstanter Geschwindigkeitswert zugeordnet ist, oder eine zeitliche Abfolge mehrerer Zeitintervalle, welchen jeweils ein konstanter Geschwindigkeitswert zugeordnet ist.

Ein aktuelles Zeitintervall eines Fahrzyklus im Sinne der Erfindung ist insbesondere ein Zeitintervall, welches sich unmittelbar an vergangene Zeitintervalle des Fahrzyklus anschließt und welchem ein aktueller Geschwindigkeitswert zugeordnet ist, welcher einen endlichen Betrag haben oder null betragen kann.

Ein Geschwindigkeitsverlauf der Vergangenheit im Sinne der Erfindung ist insbesondere ein aktuelles Zeitintervall, dem ein Geschwindigkeitswert zugeordnet ist und/oder ein vergangenes Zeitintervall, dem ein Geschwindigkeitswert zugeordnet ist, und/oder eine Vielzahl vergangener Zeitintervalle, denen jeweils ein Geschwindigkeitswert zugeordnet ist. Ein Geschwindigkeitswert kann einen endlichen Betrag haben oder null sein.

Ein Beschleunigungswert im Sinne der Erfindung ist ein positiver Wert im Falle einer positiven Beschleunigung oder ein negativer Wert im Falle einer negativen Beschleunigung, hier auch Entschleunigung genannt.

Ein Zustandsvektor eines Fahrzyklus für ein aktuelles Zeitintervall im Sinne der Erfindung ist insbesondere ein Vektor, dessen Komponenten einem oder mehreren Geschwindigkeitswerten und/oder einem oder mehreren Beschleunigungswerten und/oder einem oder mehreren Werten einer Beschleunigungsänderung und/oder einem oder mehreren Werten entsprechen, welche eine Anzahl von Zeitintervallen anzeigen.

Ein Beschleunigungsprognosemodell im Sinne der Erfindung ist insbesondere ein Modell zur Bestimmung eines oder mehrerer Beschleunigungswerte für ein aktuelles Zeitintervall oder für ein oder mehrere Zeitintervalle, welche zeitlich auf das aktuelle Zeitintervall folgen. Ein Beschleunigungsprognosemodell im Sinne der Erfindung kann auch als bedingte Beschleunigungsprognose, engl. Conditional Acceleration Prediction (CAP) bezeichnet werden.

Die Erfindung basiert insbesondere auf dem Ansatz, dass aus einem Geschwindigkeitsverlauf der Vergangenheit, also mindestens einem Geschwindigkeitswert, welcher einem aktuellen Zeitintervall und/oder mindestens einem vergangenen Zeitintervall zugeordnet ist, ein Zustandsvektor ermittelt wird, welcher den aktuellen Zustand eines Fahrzyklus zu einem aktuellen Zeitintervall repräsentiert, und mithilfe des Zustandsvektors und eines wahrscheinlichkeitsbasierten Beschleunigungsprognosemodells ein Beschleunigungswert für das aktuelle Zeitintervall bestimmt wird. Durch Integration des so bestimmten Beschleunigungswerts über das aktuelle Zeitintervall wird ein vorhergesagter Geschwindigkeitswert für ein zukünftiges Zeitintervall erhalten, welcher an den Geschwindigkeitsverlauf der Vergangenheit angehängt wird.

Das computergestützte Verfahren zum Erzeugen eines Fahrzyklus für ein Fahrzeug gemäß der vorliegenden Erfindung hat gegenüber dem Stand der Technik den Vorteil, dass beliebig viele Fahrzyklen erzeugt werden können, welche einerseits sich in ihrem Geschwindigkeitsverlauf untereinander nicht ähneln und andererseits durch Verwendung des Beschleunigungsprognosemodells große Ähnlichkeit mit unter realen Bedingungen gemessenen Fahrzyklen aufweisen.

In einer bevorzugten Ausführungsform des Verfahrens zum Erzeugen eines Fahrzyklus weist das Bestimmen eines Beschleunigungswerts unter Berücksichtigung von Wahrscheinlichkeiten, welche sich aus dem Beschleunigungsprognosemodell und dem Zustandsvektor ergeben, ein Ermitteln, mittels des Beschleunigungsprognosemodells in Abhängigkeit des Zustandsvektors, eines Wahrscheinlichkeitswerts für ein aktuelles Szenario einer Beschleunigung und eines Wahrscheinlichkeitswerts für ein aktuelles Szenario einer Entschleunigung und eines Wahrscheinlichkeitswerts für ein aktuelles Szenario eines Zustands konstanter Geschwindigkeit auf. Das Bestimmen eines Beschleunigungswerts unter Berücksichtigung von Wahrscheinlichkeiten weist weiterhin ein zufälliges Auswählen, für das aktuelle Zeitintervall, eines Szenarios der Beschleunigung, der Entschleunigung oder der konstanten Geschwindigkeit basierend auf den Wahrscheinlichkeitswerten für aktuelle Szenarien einer Beschleunigung, einer Entschleunigung und einer konstanten Geschwindigkeit und/oder ein Ermitteln, mittels des Beschleunigungsprognosemodells in Abhängigkeit des Zustandsvektors, einer Wahrscheinlichkeitsverteilung von Beschleunigungswerten des zufällig ausgewählten Szenarios und ein zufälliges Auswählen, für das aktuelle Zeitintervall, eines Beschleunigungswerts basierend auf der Wahrscheinlichkeitsverteilung von Beschleunigungswerten des zufällig ausgewählten Szenarios auf.

Ein aktuelles Szenario im Sinne der Erfindung ist insbesondere eine Beschleunigung, eine Entschleunigung oder ein Zustand konstanter Geschwindigkeit in einem aktuellen Zeitintervall.

Ein zufälliges Auswählen im Sinne der Erfindung ist insbesondere eine Ziehung einer Zufallsstichprobe bzw. eine Zufallsziehung im statistischen Sinne.

Das zufällige Auswählen eines Szenarios einer Beschleunigung, einer Entschleunigung oder einer konstanten Geschwindigkeit basierend auf Wahrscheinlichkeitswerten für aktuelle Szenarien der Beschleunigung, der Entschleunigung und der konstanten Geschwindigkeit sowie das zufällige Auswählen eines Beschleunigungswerts für das aktuelle Zeitintervall basierend auf einer Wahrscheinlichkeitsverteilung von Beschleunigungswerten hat folgende Vorteile: Ausgehend von demselben Geschwindigkeitsverlauf der Vergangenheit können mithilfe des Beschleunigungsprognosemodells eine Vielzahl von Fahrzyklen generiert werden, welche untereinander keine Ähnlichkeit aufweisen. Darüber hinaus bieten diese eine hinreichende Variabilität, um den insbesondere durchschnittlichen Verbrauch eines Fahrzeugs unter realen Fahrbedingungen zu bestimmen.

In einer weiteren bevorzugten Ausführungsform des Verfahrens zum Erzeugen eines Fahrzyklus wird der Fahrzyklus durch iteratives Ausführen der Arbeitsschritte des Verfahrens in aufgeführter Reihenfolge erzeugt und die vorhergesagten Geschwindigkeitswerte werden jeweils an den Geschwindigkeitsverlauf der Vergangenheit aus einer vorhergehenden Iteration angehängt. Dies hat den Vorteil, dass ein Fahrzyklus beliebiger Länge erzeugt werden kann.

In einer weiteren bevorzugten Ausführungsform des Verfahrens zum Erzeugen eines Fahrzyklus werden basierend auf dem Geschwindigkeitsverlauf der Vergangenheit für dieselben Zeitintervalle in der Zukunft jeweils mehrere vorhergesagte Geschwindigkeitswerte erhalten, so dass für Zeitintervalle in der Zukunft statistische Geschwindigkeitsverteilungen erhalten werden. Die statistischen Geschwindigkeitsverteilungen für die Zeitintervall in der Zukunft erlauben eine statistische Auswertung des erzeugten Fahrzyklus. Beispielsweise kann so ein Fahrzyklus erstellt werden, dessen Geschwindigkeitswerte dem jeweiligen Erwartungswert der statistischen Geschwindigkeitsverteilungen entsprechen.

In einer weiteren bevorzugten Ausführungsform des Verfahrens zum Erzeugen eines Fahrzyklus weist der Zustandsvektor für ein aktuelles Zeitintervall wenigstens einen aktuellen Geschwindigkeitswert und/oder einen oder mehrere Geschwindigkeitswerte der Vergangenheit und/oder einen oder mehrere Beschleunigungswerte eines oder mehrerer Zeitintervalle und/oder einen oder mehrere Werte einer Beschleunigungsänderung eines oder mehrerer Zeitintervalle und/oder einen Wert entsprechend einer Anzahl von Zeitintervallen gemäß der Dauer eines aktuell andauernden Beschleunigungsmanövers und/oder einen Wert entsprechend einer Anzahl von Zeitintervallen gemäß der Dauer eines aktuell andauernden Entschleunigungsmanövers und/oder einen Wert entsprechend einer Anzahl von Zeitintervallen gemäß der Dauer eines aktuell andauernden Zustands konstanter Geschwindigkeit.

Eine Beschleunigungsänderung eines Zeitintervalls im Sinne der Erfindung ist insbesondere die Differenz zwischen einem Beschleunigungswert innerhalb des Zeitintervalls und einem Beschleunigungswert in einem vorhergehenden Zeitintervall.

Ein Beschleunigungsmanöver im Sinne der Erfindung ist insbesondere ein ununterbrochener Beschleunigungsvorgang beliebiger Beschleunigungswerte über ein oder mehrere Zeitintervalle hinweg, welcher in der Vergangenheit, d.h. in einem vergangenen Zeitintervall vor dem aktuellen Zeitintervall, begonnen hat. Ein aktuell andauerndes Beschleunigungsmanöver bedeutet, dass das Beschleunigungsmanöver bis zu dem Zeitintervall unmittelbar vor dem aktuellen Zeitintervall andauert.

Ein Entschleunigungsmanöver im Sinne der Erfindung ist insbesondere ein ununterbrochener Vorgang einer Entschleunigung beliebiger negativer Beschleunigungswerte über ein oder mehrere Zeitintervalle hinweg, welches in der Vergangenheit, d.h. in einem vergangenen Zeitintervall vor dem aktuellen Zeitintervall, begonnen hat. Ein aktuell andauerndes Entschleunigungsmanöver bedeutet, dass das Entschleunigungsmanöver bis zu dem Zeitintervall unmittelbar vor dem aktuellen Zeitintervall andauert.

Ein Zustand konstanter Geschwindigkeit im Sinne der Erfindung ist insbesondere das Beibehalten eines konstanten Geschwindigkeitswerts über ein oder mehrere Zeitintervalle hinweg, welches in der Vergangenheit, d. h. in einem vergangenen Zeitintervall vor dem aktuellen Zeitintervall, begonnen hat. Ein aktuell andauernder Zustand konstanter Geschwindigkeit bedeutet, dass der Zustand konstanter Geschwindigkeit bis zu dem Zeitintervall unmittelbar vor dem aktuellen Zeitintervall andauert.

Da der Zustandsvektor eines aktuellen Zeitintervalls einen Wert gemäß der Dauer eines aktuell anhaltenden Beschleunigungsmanövers, einen Wert gemäß der Dauer eines aktuell anhaltenden Entschleunigungsmanövers und/oder einen Wert gemäß der Dauer eines aktuell anhaltenden Zustands konstanter Geschwindigkeit aufweist, hat die Dauer von Beschleunigungsmanövern, Entschleunigungsmanövern und/oder die Dauer eines Zustands konstanter Geschwindigkeit innerhalb eines bereits generierten Teils eines Fahrzyklus Einfluss auf den weiteren Verlauf des Fahrzyklus.

Gemäß dem realen Fahrverhalten eines Fahrzeugs wird die nach der vorliegenden Erfindung ermittelte Wahrscheinlichkeit für die Fortsetzung des Beschleunigungsmanövers im aktuellen Zeitintervall und in zukünftigen Zeitintervallen eines Fahrzyklus von der Dauer eines Beschleunigungsmanövers in der Vergangenheit des Fahrzyklus beeinflusst. Entsprechendes gilt für Entschleunigungsmanöver und Zustände konstanter Geschwindigkeit. Auch die ermittelte Wahrscheinlichkeitsverteilung von Beschleunigungswerten eines zufällig ausgewählten Szenarios für ein aktuelles Zeitintervall und zukünftige Zeitintervalle ist abhängig von der Dauer eines Beschleunigungsmanövers, Entschleunigungsmanövers oder Zustands konstanter Geschwindigkeit in der Vergangenheit des Fahrzyklus. Dies hat den Vorteil, dass die Ähnlichkeit des generierten Fahrzyklus zu unter realen Bedingungen gemessenen Fahrzyklen weiter gesteigert wird.

In einer weiteren bevorzugten Ausführungsform des Verfahrens zum Erzeugen eines Fahrzyklus basiert der Beschleunigungswert, welcher unter Berücksichtigung von sich aus dem Beschleunigungsprognosemodell und dem Zustandsvektor ergebenden Wahrscheinlichkeiten bestimmt wird, auf der Dauer eines aktuell andauernden Beschleunigungsmanövers, eines aktuell andauernden Entschleunigungsmanövers oder eines aktuell andauernden Zustands konstanter Geschwindigkeit. Dies hat den Vorteil, dass die Dauer eines Beschleunigungsmanövers, eines Entschleunigungsmanövers oder eines Zustands konstanter Geschwindigkeit an reale Fahrbedingung angepasst werden und so die Ähnlichkeit des erzeugten Fahrzyklus mit unter realen Bedingungen gemessenen Fahrzyklen weiter gesteigert werden kann.

In einer weiteren bevorzugten Ausführungsform des Verfahrens zum Erzeugen eines Fahrzyklus weist der Geschwindigkeitsverlauf der Vergangenheit mindestens einen Geschwindigkeitswert auf. Der mindestens eine Geschwindigkeitswert kann einen endlichen Betrag haben oder null sein. Dies hat den Vorteil, dass ein Fahrzyklus aus einem einzelnen Geschwindigkeitswert erzeugt werden kann.

In einer weiteren bevorzugten Ausführungsform des Verfahrens zum Erzeugen eines Fahrzyklus weist das aktuelle Szenario einer Beschleunigung und/oder das aktuelle Szenario einer Entschleunigung und/oder das aktuelle Szenario eines Zustands konstanter Geschwindigkeit jeweils eine Wahrscheinlichkeitsverteilung von Beschleunigungswerten auf. Dies ermöglicht eine statistische Auswertung des erzeugten Fahrzyklus. Beispielsweise kann so ein Fahrzyklus erstellt werden, dessen Geschwindigkeitswerte auf Beschleunigungswerten basieren, welche dem jeweiligen Erwartungswert der Wahrscheinlichkeitsverteilungen von Beschleunigungswerten in den einzelnen Zeitintervallen entsprechen.

In einer weiteren bevorzugten Ausführungsform des Verfahrens zum Erzeugen eines Fahrzyklus wird ein Erwartungswert der Wahrscheinlichkeitsverteilung von Beschleunigungswerten basierend auf dem Geschwindigkeitsverlauf der Vergangenheit eingestellt. Vorzugsweise wird der Erwartungswert der modellierten Wahrscheinlichkeitsverteilung basierend auf dem aktuellen Geschwindigkeitswert und einem Geschwindigkeitswert aus der Vergangenheit abgeleitet. Vorzugsweise wird der Erwartungswert der modellierten Wahrscheinlichkeitsverteilung basierend auf dem aktuellen Geschwindigkeitswert und dem direkten zeitlichen Vorgänger des aktuellen Geschwindigkeitswerts eingestellt. Dies hat den Vorteil, dass der zeitliche Geschwindigkeitsverlauf des Fahrzyklus einen glatten bzw. stetigen Verlauf aufweist. Zeitlich abrupte Sprünge des Geschwindigkeitsverlaufs des generierten Fahrzyklus werden somit vermieden, was seine Ähnlichkeit mit unter realen Bedingungen gemessenen Fahrzyklen nochmals steigert.

In einer weiteren bevorzugten Ausführungsform des Verfahrens zum Erzeugen eines Fahrzyklus basiert das Beschleunigungsprognosemodell auf einer statistischen Auswertung von gemessenen Fahrdaten wenigstens eines realen Fahrzeugs, wobei vorzugsweise die gemessenen Fahrtdaten des wenigstens einen realen Fahrzeugs ausschließlich eine zeitliche Abfolge von Geschwindigkeitswerten aufweisen. Vorzugsweise werden die unter realen Fahrbedingungen gemessenen Fahrdaten des realen Fahrzeugs für ein Modelltraining, insbesondere für die Bestimmung von Modellparametern, verwendet. Dies hat den Vorteil, dass die Ähnlichkeit der mithilfe des Beschleunigungsprognosemodells erzeugten Fahrzyklen mit unter realen Bedingungen gemessenen Fahrzyklen gesteigert wird.

Ein weiterer Aspekt der Erfindung betrifft ein Verfahren zum Führen eines Fahrzeugs mittels eines Systems adaptiver Fahrtregelung, insbesondere eines Fahrerassistenzsystems, insbesondere für prädiktive Fahrfunktionen, wobei der Fahrzyklus des dem Fahrzeug vorausfahrenden Fahrzeugs mittels eines computergestützten Verfahrens nach einer der genannten Ausführungsformen bestimmt wird.

In einer bevorzugten Ausführungsform des Verfahrens zum Führen eines Fahrzeugs wird der Abstand zwischen dem Fahrzeug und dem vorausfahrenden Fahrzeug nicht als Eingabewert oder Randbedingung für die adaptive Fahrtregelung verwendet, wobei vorzugsweise der Abstand zwischen dem Fahrzeug und dem vorausfahrenden Fahrzeug auf einer Lösung einer Kostenfunktion bzw. Kostenoptimierungsfunktion basiert. Der Abstand zwischen dem Fahrzeug und dem vorausfahrenden Fahrzeug ist somit keine konstante Größe, was den Vorteil hat, dass der Abstand an aktuelle Verkehrsbedingungen angepasst werden kann.

In einer weiteren bevorzugten Ausführungsform des Verfahrens zum Führen eines Fahrzeugs werden basierend auf dem Geschwindigkeitsverlauf der Vergangenheit für dieselben Zeitintervalle in der Zukunft mehrere vorhergesagte Geschwindigkeitswerte erhalten, so dass für Zeitintervalle in der Zukunft statistische Geschwindigkeitsverteilungen erhalten werden, wobei aus den statistischen Geschwindigkeitsverteilungen Sicherheitsbedingungen für das Führen des Fahrzeugs abgeleitet werden. Zu diesen Sicherheitsbedingungen für das Führen des Fahrzeugs gehört insbesondere das Bestimmen eines minimalen Abstands zwischen dem Fahrzeug und dem vorausfahrenden Fahrzeug, welcher eingehalten werden muss, um eine Kollision der beiden Fahrzeuge zu verhindern. Dadurch kann die Sicherheit bei dem Führen des Fahrzeugs erhöht werden.

Ein weiterer Aspekt der Erfindung betrifft ein Verfahren zum Erzeugen eines Fahrzyklus für ein Fahrzeug, welches sich zur Verwendung durch Fahrerassistenzsysteme, insbesondere für prädiktive Fahrfunktionen, eignet und die Arbeitsschritte eines Verfahrens zum Erzeugen eines Fahrzyklus nach einer der genannten Ausführungsformen aufweist.

Ein weiterer Aspekt der Erfindung betrifft ein Verfahren zum Analysieren wenigstens einer Komponente eines Kraftfahrzeugs, wobei die wenigstens eine Komponente oder das Kraftfahrzeug einem realen oder simulierten Prüfbetrieb auf der Grundlage mindestens eines Fahrzyklus unterzogen wird, welcher mittels eines Verfahrens zum Erzeugen eines Fahrzyklus nach einer der genannten Ausführungsformen bestimmt wird.

Weiter vorzugsweise weist das Verfahren zum Analysieren wenigstens einer Komponente eines Kraftfahrzeugs ein Überprüfen der Konformität der mehreren vorhergesagten Geschwindigkeitswerte mit wenigstens einer Randbedingung, insbesondere Real-Driving-Emissions-(RDE-)Richtlinien, nach Ablauf einer definierten Anzahl von Iterationen auf, wobei insbesondere das Überprüfen periodisch wiederkehrend jeweils nach Ablauf der bestimmten Anzahl von Iterationen erfolgt, wobei insbesondere die bestimmte Anzahl von Iterationen einem vordefinierten Gesamtzeitintervall, beispielsweise von 5 Minuten, entspricht. Dies hat den Vorteil, dass RDE-richtlinienkonforme Fahrzyklen erzeugt werden können.

Weiter vorzugsweise weist das Verfahren zum Analysieren wenigstens einer Komponente eines Kraftfahrzeugs ein Korrigieren, für das aktuelle Zeitintervall, basierend auf dem Überprüfen, des Wahrscheinlichkeitswerts für ein aktuelles Szenario einer Beschleunigung und/oder des Wahrscheinlichkeitswerts für ein aktuelles Szenario einer Entschleunigung und/oder des Wahrscheinlichkeitswerts für ein aktuelles Szenario eines Zustands konstanter Geschwindigkeit und/oder ein Korrigieren des Beschleunigungswerts für das aktuelle Zeitintervall basierend auf dem Überprüfen auf. Dies hat den Vorteil, dass RDE-richtlinienkonforme Fahrzyklen erzeugt werden können.

Ein weiterer Aspekt der Erfindung betrifft ein Computerprogrammprodukt, das Anweisungen aufweist, welche, wenn sie von einem Computer ausgeführt werden, diesen dazu veranlassen, die Schritte eines Verfahrens gemäß einer der genannten Ausführungsformen auszuführen.

Ein weiterer Aspekt der Erfindung betrifft ein Computer-lesbares Medium, auf dem ein Computerprogrammprodukt gemäß einer der genannten Ausführungsformen gespeichert ist.

Ein weiterer Aspekt der Erfindung betrifft eine Vorrichtung zum Erzeugen eines Fahrzyklus für ein Fahrzeug, welche sich zur Simulation eines, insbesondere realen, Fahrbetriebs eignet, und Mittel zum Ermitteln eines Zustandsvektors des Fahrzyklus für ein aktuelles Zeitintervall aus einem Geschwindigkeitsverlauf der Vergangenheit, Mittel zum Bereitstellen eines Beschleunigungsprognosemodells, Mittel zum Bestimmen eines Beschleunigungswerts unter Berücksichtigung von Wahrscheinlichkeiten, welche sich aus dem Beschleunigungsprognosemodell und dem Zustandsvektor ergeben, Mittel zum Integrieren des ausgewählten Beschleunigungswerts über das aktuelle Zeitintervall, um einen vorhergesagten Geschwindigkeitswert für ein nächstes Zeitintervall in der Zukunft zu erhalten und Mittel zum Anhängen des vorhergesagten Geschwindigkeitswerts an den Geschwindigkeitsverlauf der Vergangenheit zum Erzeugen des Fahrzyklus aufweist.

Ein Mittel im Sinne der Erfindung kann hard- und/oder softwaretechnisch ausgebildet sein und insbesondere eine, vorzugsweise mit einem Speicher- und/oder Bussystem daten- bzw. signalverbundene, insbesondere digitale, Verarbeitungs-, insbesondere Mikroprozessoreinheit (CPU) und/oder ein oder mehrere Programme oder Programmmodule aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus abzugeben. Ein Speichersystem kann ein oder mehrere, insbesondere verschiedene, Speichermedien, insbesondere optische, magnetische, Festkörper- und/oder andere nicht-flüchtige Medien, aufweisen. Das Programm kann derart beschaffen sein, dass es die hier beschriebenen Verfahren verkörpert bzw. auszuführen imstande ist, so dass die CPU die Schritte solcher Verfahren ausführen kann und damit insbesondere eine Hubkolbenmaschine steuern und/oder überwachen kann.

Weitere Merkmale und Vorteile ergeben sich aus der nachfolgenden Beschreibung in Verbindung mit den Figuren. Die Figuren zeigen wenigstens teilweise schematisch:
- **Fig. 1**: ein bevorzugtes Ausführungsbeispiel eines erfindungsgemäßen computergestützten Verfahrens zum Erzeugen eines Fahrzyklus für ein Fahrzeug, wobei sich das Verfahren zur Simulation eines realen Fahrbetriebs eignet;
- **Fig. 2**: ein bevorzugtes Ausführungsbeispiel eines erfindungsgemäßen computergestützten Verfahrens zum Erzeugen eines RDE-konformen Fahrzyklus für ein Fahrzeug; und
- **Fig. 3**: ein bevorzugtes Ausführungsbeispiel einer Vorrichtung zum Erzeugen eines Fahrzyklus für ein Fahrzeug, welche sich zur Simulation eines realen Fahrbetriebs eignet.

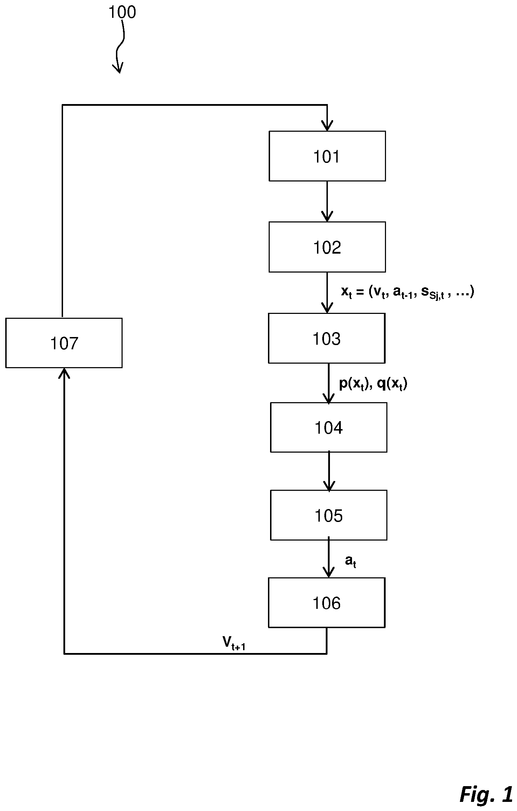

**Fig. 1** zeigt ein bevorzugtes Ausführungsbeispiel eines erfindungsgemäßen computergestützten Verfahrens 100 zum Erzeugen eines Fahrzyklus für ein Fahrzeug, wobei sich das Verfahren 100 zur Simulation eines realen Fahrbetriebs eignet.

In einem Schritt 101 des Verfahrens 100 werden Daten der Vergangenheit bereitgestellt. Die Daten der Vergangenheit stellen Geschwindigkeitsdaten der Vergangenheit bzw. einen Geschwindigkeitsverlauf der Vergangenheit dar und bestehen aus Geschwindigkeitswerten, welche jeweils aufeinanderfolgenden definierten Zeitintervallen zugeordnet sind. Die definierten Zeitintervalle können konstante Zeitintervalle sein oder in ihrer zeitlichen Länge variieren. Die Daten der Vergangenheit können aus einem einzigen Geschwindigkeitswert bestehen, welcher einem einzigen Zeitintervall zugeordnet ist. Dieser einzige Geschwindigkeitswert kann auch null betragen. Der zeitlich letzte Geschwindigkeitswert des Geschwindigkeitsverlaufs der Vergangenheit ist einem aktuellen Zeitintervall zugeordnet.

In einem Schritt 102 wird für das aktuelle Zeitintervall der Zustandsvektor xt aus den Geschwindigkeitsdaten bzw. dem Geschwindigkeitsverlauf der Vergangenheit ermittelt. Der Zustandsvektor xt hat als Komponenten den aktuellen Geschwindigkeitswert vt des aktuellen Zeitintervalls t, den Beschleunigungswert aₜ₋₁ des Zeitintervalls t-1, welches sich unmittelbar vor dem aktuellen Zeitintervall t befindet, einen Wert s_{a,t}, welcher der Anzahl von Zeitintervallen entspricht, in denen unmittelbar vor dem aktuellen Zeitintervall ein Beschleunigungsmanöver stattgefunden hat, einen Wert s_{e,t}, welcher der Anzahl von Zeitintervallen entspricht, in denen unmittelbar vor dem aktuellen Zeitintervall ein Entschleunigungsmanöver stattgefunden hat, sowie ein Wert s_{k,t}, welcher der Anzahl von Zeitintervallen entspricht, in denen unmittelbar vor dem aktuellen Zeitintervall ein Zustand konstanter Geschwindigkeit angehalten hat.

Die in Fig. 1 verwendete Bezeichnung s_{j,t} bezeichnet die drei Werte s_{a,t}, s_{e,t} und s_{k,t}, wobei der Index j entweder a für ein Beschleunigungsmanöver, e für ein Entschleunigungsmanöver oder k für einen Zustand konstanter Geschwindigkeit annehmen kann. Der Zustandsvektor kann weitere Komponenten oder andere Komponenten besitzen, welche Geschwindigkeitswerten, Beschleunigungswerten, Änderungen von Beschleunigungswerten oder einer Anzahl von Zeitintervallen entsprechen.

In einem Schritt 103 werden aus dem Zustandsvektor mithilfe eines Beschleunigungsprognosemodells ein Wahrscheinlichkeitswert p(xt) für ein aktuelles Beschleunigungsszenario und ein Wahrscheinlichkeitswert q(xt) für ein aktuelles Entschleunigungsszenario ermittelt. Der Wahrscheinlichkeitswert y für einen Zustand konstanter Geschwindigkeit ergibt sich dann vorzugsweise aus der folgenden Beziehung y = 1-p(xₜ)-q(xₜ). Das Beschleunigungsprognosemodell basiert vorzugsweise auf einer statistischen Auswertung von gemessenen Fahrdaten eines realen Fahrzeugs, wobei die gemessenen Fahrdaten ausschließlich aus einer zeitlichen Abfolge von Geschwindigkeitswerten bestehen, welche zeitlich aufeinander folgenden Zeitintervallen zugeordnet sind.

In einem Schritt 104 erfolgt dann ein zufälliges Auswählen im Sinne einer statistischen Zufallsziehung eines der drei Szenarien, also ein Beschleunigungsszenario, ein Entschleunigungsszenario oder das Szenario des Zustands einer konstanten Geschwindigkeit basierend auf den in Schritt 103 ermittelten Wahrscheinlichkeitswerten p(xt), q(xt) und 1-p(xt)-q(xt).

Mithilfe des Beschleunigungsprognosemodells wird in Abhängigkeit des Zustandsvektors für das zufällig ausgewählte Szenario eine Wahrscheinlichkeitsverteilung von Beschleunigungswerten ermittelt, vorzugsweise wird hierfür eine kontinuierliche Wahrscheinlichkeitsverteilung modelliert. Weiter vorzugsweise kann jedem möglichen Beschleunigungswert innerhalb des zufällig ausgewählten Szenarios eine Wahrscheinlichkeit zugeordnet werden.

In einem Schritt 105 erfolgt ein zufälliges Auswählen im Sinne einer statistischen Zufallsziehung eines beliebigen Beschleunigungswerts at für das aktuelle Zeitintervall t aus der ermittelten Wahrscheinlichkeitsverteilung des zufällig ausgewählten Szenarios.

In einem Schritt 106 wird der zufällig ausgewählte Beschleunigungswert at über das aktuelle Zeitintervall t integriert, um einen nächsten, vorhergesagten Geschwindigkeitswert vₜ₊₁ für ein nächstes Zeitintervall t+1 in der Zukunft zu erhalten.

In einem Schritt 107 wird der neue Geschwindigkeitswert vₜ₊₁ an den Geschwindigkeitsverlauf der Vergangenheit angehängt. Der neue Geschwindigkeitswert vₜ₊₁ für das Zeitintervall t+1 wird anschließend in einer zweiten Iteration des Verfahrens in dem Schritt 102 als aktuelles Zeitintervall behandelt. Durch ein iteratives Durchlaufen der Schritte 102 bis 107 wird ein Fahrzyklus erstellt, welcher aufgrund der Beschaffenheit des Beschleunigungsprognosemodells ähnlich zu einem unter realen Bedingungen gemessenen Fahrzyklus ist.

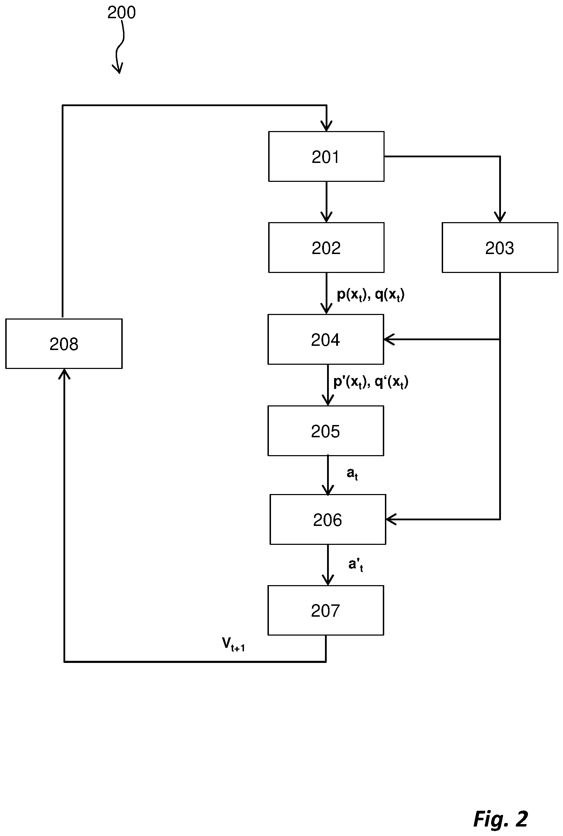

**Fig. 2** zeigt ein bevorzugtes Ausführungsbeispiel eines erfindungsgemäßen computergestützten Verfahrens 200 zum Erzeugen eines RDE-konformen Fahrzyklus für ein Fahrzeug.

Schritt 201 des Verfahrens 200 ist mit dem oben beschriebenen Schritt 101 des Verfahrens 100 identisch. Geschwindigkeitsdaten der Vergangenheit werden bereitgestellt.

Schritt 202 des Verfahrens 200 beinhaltet die oben beschriebenen Schritte 102 und 103 des Verfahrens 100. Für das aktuelle Zeitintervall wird der Zustandsvektor xt aus dem Geschwindigkeitsverlauf der Vergangenheit ermittelt. Aus dem Zustandsvektor werden mithilfe des Beschleunigungsprognosemodells ein Wahrscheinlichkeitswert p(xt) für ein aktuelles Beschleunigungsszenario und ein Wahrscheinlichkeitswert q(xt) für ein aktuelles Entschleunigungsszenario ermittelt.

Nachdem mehrere vorhergesagte Geschwindigkeitswerte durch iteratives Ausführen des Verfahrens 100 erhalten und an den Geschwindigkeitsverlauf der Vergangenheit angehängt wurden, erfolgt in Schritt 203 des Verfahrens 200 periodisch wiederkehrend nach Ablauf einer definierten Anzahl von Iterationen des Verfahrens 100 eine Überprüfung der bisher vorhergesagten, d.h. bisher generierten Geschwindigkeitswerte auf Konformität mit den Kriterien der RDE-Richtlinien. Beispielsweise kann diese periodisch wiederkehrende Überprüfung jeweils nach einer Anzahl von Zeitintervallen erfolgen, welche dem Ablauf einer Zeitspanne von fünf Minuten des Fahrzyklus entsprechen, andere Zeitspannen zur periodischen Überprüfung sind jedoch auch möglich.

Nachdem in Schritt 202 die Wahrscheinlichkeitswerte p(xt) und q(xt) für ein aktuelles Beschleunigungsszenario und für ein aktuelles Entschleunigungsszenario ermittelt wurden, werden, falls die Überprüfung in Schritt 203 ergeben hat, dass Kriterien der RDE-Richtlinien durch die bereits vorhergesagten, an den Geschwindigkeitsverlauf der Vergangenheit angehängten Geschwindigkeitswerte nicht eingehalten werden, die ermittelten Wahrscheinlichkeitswerte p(xt) und q(xt) in einem Schritt 204 entsprechend korrigiert.

Das aktuelle Beschleunigungsszenario bzw. Entschleunigungsszenario erhält somit korrigierte Wahrscheinlichkeitswerte p'(xt) und q'(xt). Wenn beispielsweise die Überprüfung in Schritt 203 ergeben hat, dass die Zeitdauer einer Autobahnfahrt bei erhöhter Geschwindigkeit gemäß den Kriterien der RDE-Richtlinien durch die bereits vorhergesagten Geschwindigkeitswerte und entsprechenden Zeitintervalle nicht eingehalten wird, wird in Schritt 204 die Wahrscheinlichkeit für ein Beschleunigungsszenario durch die Korrektur erhöht und die Wahrscheinlichkeit für ein Entschleunigungsszenario entsprechend verringert.

In einem Schritt 205 erfolgt anschließend ein zufälliges Auswählen eines der drei Szenarien, also ein Beschleunigungsszenario, ein Entschleunigungsszenario oder ein Szenario des Zustands einer konstanten Geschwindigkeit basierend auf den durch Schritt 204 korrigierten Wahrscheinlichkeitswerten p'(xₜ), q'(xt) und 1- p'(xt)-q'(xt) und ein zufälliges Auswählen eines beliebigen Beschleunigungswerts at aus der wie im Kontext des Verfahrens 100 beschriebenen, ermittelten Wahrscheinlichkeitsverteilung des zufällig ausgewählten Szenarios.

Alternativ oder zusätzlich zu der Korrektur in Schritt 204 kann in Schritt 206 gemäß der Überprüfung in Schritt 203 eine Korrektur des zufällig ausgewählten Beschleunigungswerts at erfolgen, wodurch der korrigierte Beschleunigungswert a't erzeugt wird.

In einem Schritt 207 wird der korrigierte Beschleunigungswert a't über das aktuelle Zeitintervall t integriert, um einen nächsten, vorhergesagten Geschwindigkeitswert vₜ₊₁ für ein nächstes Zeitintervall t+1 in der Zukunft zu erhalten.

In einem Schritt 208 wird der neue Geschwindigkeitswert vₜ₊₁ an den Geschwindigkeitsverlauf der Vergangenheit angehängt. Der neue Geschwindigkeitswert vₜ₊₁ für das Zeitintervall t+1 wird anschließend in der nächsten Iteration des Verfahrens 200 in dem Schritt 202 als aktuelles Zeitintervall behandelt. Durch ein iteratives Durchlaufen der Schritte 202 bis 208 wird ein Fahrzyklus erstellt, welcher aufgrund der Beschaffenheit des Beschleunigungsprognosemodells ähnlich zu einem unter realen Bedingungen gemessenen Fahrzyklus und RDErichtlinienkonform ist.

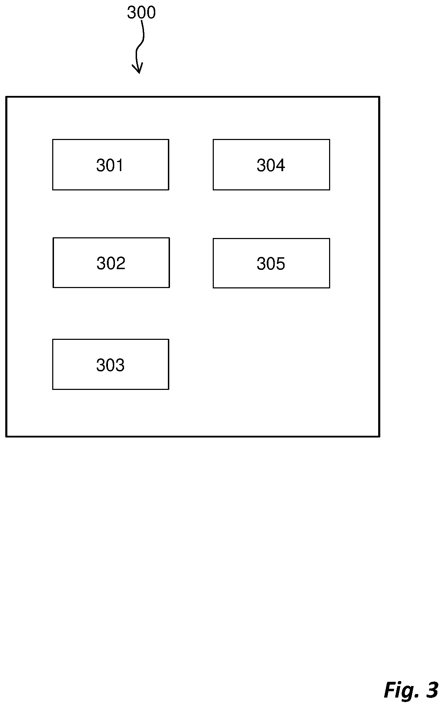

**Fig. 3** zeigt ein bevorzugtes Ausführungsbeispiel einer Vorrichtung 300 zum Erzeugen eines Fahrzyklus für ein Fahrzeug, welche sich zur Simulation eines realen Fahrbetriebs eignet. Die Vorrichtung zum Erzeugen des Fahrzyklus für ein Fahrzeug weist Mittel 301 zum Ermitteln eines Zustandsvektors des Fahrzyklus für ein aktuelles Zeitintervall aus einem Geschwindigkeitsverlauf der Vergangenheit auf. Weiterhin weist die Vorrichtung zum Erzeugen des Fahrzyklus Mittel 302 zum Bereitstellen eines Beschleunigungsprognosemodells, Mittel 303 zum Bestimmen eines Beschleunigungswerts unter Berücksichtigung von Wahrscheinlichkeiten, welche sich aus dem Beschleunigungsprognosemodell und dem Zustandsvektor ergeben, Mittel 304 zum Integrieren des bestimmten Beschleunigungswerts über das aktuelle Zeitintervall, um einen vorhergesagten Geschwindigkeitswert für ein nächstes Zeitintervall in der Zukunft zu erhalten und Mittel 305 zum Anhängen des vorhergesagten Geschwindigkeitswerts an den Geschwindigkeitsverlauf der Vergangenheit zum Erzeugen des Fahrzyklus auf.

### Bezugszeichenliste

- 300: Vorrichtung zum Erzeugen eines Fahrzyklus für ein Fahrzeug
- 301: Mittel zum Ermitteln eines Zustandsvektors des Fahrzyklus
- 302: Mittel zum Bereitstellen eines Beschleunigungsprognosemodells
- 303: Mittel zum Bestimmen eines Beschleunigungswerts
- 304: Mittel zum Integrieren des bestimmten Beschleunigungswerts
- 305: Mittel zum Anhängen des vorhergesagten Geschwindigkeitswerts an den Geschwindigkeitsverlauf der Vergangenheit

## Patentansprüche

1. Computergestütztes Verfahren (100) zum Erzeugen eines Fahrzyklus für ein Fahrzeug, welches sich zur Simulation eines, insbesondere realen, Fahrbetriebs eignet, **dadurch gekennzeichnet, dass** es folgende Arbeitsschritte umfasst:
Ermitteln (102) eines Zustandsvektors des Fahrzyklus für ein aktuelles Zeitintervall aus einem Geschwindigkeitsverlauf der Vergangenheit;
Bereitstellen eines Beschleunigungsprognosemodells;
Bestimmen (103, 104, 105) eines Beschleunigungswerts unter Berücksichtigung von Wahrscheinlichkeiten, welche sich aus dem Beschleunigungsprognosemodell und dem Zustandsvektor ergeben;
Integrieren des bestimmten (106) Beschleunigungswerts über das aktuelle Zeitintervall, um einen vorhergesagten Geschwindigkeitswert für ein nächstes Zeitintervall in der Zukunft zu erhalten; und
Anhängen (107) des vorhergesagten Geschwindigkeitswerts an den Geschwindigkeitsverlauf der Vergangenheit zum Erzeugen des Fahrzyklus.

2. Verfahren nach Anspruch 1, wobei das Bestimmen (103, 104, 105) eines Beschleunigungswerts unter Berücksichtigung von Wahrscheinlichkeiten, welche sich aus dem Beschleunigungsprognosemodell und dem Zustandsvektor ergeben, folgende weitere Arbeitsschritte aufweist:
Ermitteln (103), mittels des Beschleunigungsprognosemodells in Abhängigkeit des Zustandsvektors, eines Wahrscheinlichkeitswerts für ein aktuelles Szenario einer Beschleunigung und eines Wahrscheinlichkeitswerts für ein aktuelles Szenario einer Entschleunigung und eines Wahrscheinlichkeitswerts für ein aktuelles Szenario eines Zustands konstanter Geschwindigkeit; und
Zufälliges Auswählen (104), für das aktuelle Zeitintervall, eines Szenarios der Beschleunigung, der Entschleunigung oder der konstanten Geschwindigkeit basierend auf den Wahrscheinlichkeitswerten für aktuelle Szenarien einer Beschleunigung, einer Entschleunigung und einer konstanten Geschwindigkeit; und/oder
Ermitteln, mittels des Beschleunigungsprognosemodells in Abhängigkeit des Zustandsvektors, einer Wahrscheinlichkeitsverteilung von Beschleunigungswerten des zufällig ausgewählten Szenarios; und
Zufälliges Auswählen (105), für das aktuelle Zeitintervall, eines Beschleunigungswerts basierend auf der Wahrscheinlichkeitsverteilung von Beschleunigungswerten des zufällig ausgewählten Szenarios.

3. Verfahren nach einem der Ansprüche 1 bis 2, wobei der Fahrzyklus durch iteratives Ausführen der Arbeitsschritte (102, 103 , 104, 105, 106, 107) des Verfahrens in aufgeführter Reihenfolge erzeugt wird und die vorhergesagten Geschwindigkeitswerte jeweils an den Geschwindigkeitsverlauf der Vergangenheit aus einer vorhergehenden Iteration angehängt werden.

4. Verfahren nach einem der Ansprüche 1 bis 3, wobei basierend auf dem Geschwindigkeitsverlauf der Vergangenheit für dieselben Zeitintervalle in der Zukunft jeweils mehrere vorhergesagte Geschwindigkeitswerte erhalten werden, so dass für Zeitintervalle in der Zukunft statistische Geschwindigkeitsverteilungen erhalten werden.

5. Verfahren nach einem der Ansprüche 1 bis 4, wobei der Zustandsvektor für ein aktuelles Zeitintervall wenigstens eine der folgenden Komponenten aufweist:
einen aktuellen Geschwindigkeitswert, einen oder mehrere Geschwindigkeitswerte der Vergangenheit, einen oder mehrere Beschleunigungswerte eines oder mehrerer Zeitintervalle, einen oder mehrere Werte einer Beschleunigungsänderung eines oder mehrerer Zeitintervalle, einen Wert entsprechend einer Anzahl von Zeitintervallen gemäß der Dauer eines aktuell andauernden Beschleunigungsmanövers, einen Wert entsprechend einer Anzahl von Zeitintervallen gemäß der Dauer eines aktuell andauernden Entschleunigungsmanövers und einen Wert entsprechend einer Anzahl von Zeitintervallen gemäß der Dauer eines aktuell andauernden Zustands konstanter Geschwindigkeit.

6. Verfahren nach einem der Ansprüche 1 bis 5, wobei der unter Berücksichtigung von sich aus dem Beschleunigungsprognosemodell und dem Zustandsvektor ergebenden Wahrscheinlichkeiten bestimmte Beschleunigungswert auf der Dauer eines aktuell andauernden Beschleunigungsmanövers, eines aktuell andauernden Entschleunigungsmanövers oder eines aktuell andauernden Zustands konstanter Geschwindigkeit basiert.

7. Verfahren nach einem der Ansprüche 1 bis 6, wobei das aktuelle Szenario einer Beschleunigung und/oder das aktuelle Szenario einer Entschleunigung und/oder das aktuelle Szenario eines Zustands konstanter Geschwindigkeit jeweils eine Wahrscheinlichkeitsverteilung von Beschleunigungswerten aufweisen.

8. Verfahren nach einem der Ansprüche 2 bis 7, wobei ein Erwartungswert der Wahrscheinlichkeitsverteilung von Beschleunigungswerten basierend auf dem Geschwindigkeitsverlauf der Vergangenheit eingestellt wird.

9. Verfahren nach einem der Ansprüche 1 bis 8, wobei das Beschleunigungsprognosemodell auf einer statistischen Auswertung von gemessenen Fahrdaten wenigstens eines realen Fahrzeugs basiert, wobei vorzugsweise die gemessenen Fahrtdaten des wenigstens einen realen Fahrzeugs ausschließlich eine zeitliche Abfolge von Geschwindigkeitswerten aufweisen.

10. Verfahren zum Führen eines Fahrzeugs mittels eines Systems adaptiver Fahrtregelung, insbesondere eines Fahrerassistenzsystems, insbesondere für prädiktive Fahrfunktionen, wobei der Fahrzyklus des dem Fahrzeug vorausfahrenden Fahrzeugs mittels des Verfahrens nach einem der Ansprüche 1 bis 9 bestimmt wird.

11. Verfahren nach Anspruch 10, wobei basierend auf dem Geschwindigkeitsverlauf der Vergangenheit für dieselben Zeitintervalle in der Zukunft mehrere vorhergesagte Geschwindigkeitswerte erhalten werden, so dass für Zeitintervalle in der Zukunft statistische Geschwindigkeitsverteilungen erhalten werden, wobei aus den statistischen Geschwindigkeitsverteilungen Sicherheitsbedingungen für das Führen des Fahrzeugs abgeleitet werden.

12. Verfahren zum Erzeugen eines Fahrzyklus für ein Fahrzeug, welches sich zur Verwendung durch Fahrerassistenzsysteme, insbesondere für prädiktive Fahrfunktionen, eignet und die Arbeitsschritte einer der Ansprüche 1 bis 9 aufweist.

13. Verfahren (200) zum Analysieren wenigstens einer Komponente eines Kraftfahrzeugs, wobei die wenigstens eine Komponente oder das Kraftfahrzeug einem realen oder simulierten Prüfbetrieb auf der Grundlage mindestens eines Fahrzyklus unterzogen wird, welcher mittels eines Verfahrens nach einem der Ansprüche 1 bis 9 bestimmt wird.

14. Computerprogrammprodukt oder computer-lesbares Medium, das Anweisungen aufweist, welche, wenn sie von einem Computer ausgeführt werden, diesen dazu veranlassen, die Schritte eines Verfahrens gemäß einem der Ansprüche 1 bis 13 auszuführen.

15. Computer, der zum Ausführen der Verfahrensschritte gemäß einem der Ansprüchen 1 bis 13 eingerichtet ist.

## Claims

1. Computer-aided method (100) for generating a driving cycle for a vehicle which is suitable for simulating a driving operation, in particular a real driving operation, **characterized in that** it comprises the following steps:
determining (102) a state vector of the driving cycle for a current time interval from a past velocity progression;
provision of an acceleration prediction model;
determining (103, 104, 105) an acceleration value taking into account probabilities resulting from the acceleration prediction model and the state vector;
integrating the determined (106) acceleration value over the current time interval to obtain a predicted velocity value for a next time interval in the future; and
appending (107) the predicted velocity value to the past velocity progression to generate the driving cycle.

2. The method according to claim 1, wherein determining (103, 104, 105) an acceleration value taking into account probabilities resulting from the acceleration prediction model and the state vector comprises the following further steps:
determining (103), using the acceleration prediction model as a function of the state vector, a probability value for a current scenario of acceleration and a probability value for a current scenario of deceleration and a probability value for a current scenario of a constant velocity state; and
randomly selecting (104), for the current time interval, a scenario of acceleration, deceleration or constant velocity based on the probability values for current scenarios of acceleration, deceleration and constant velocity; and/or
determining, by means of the acceleration prediction model as a function of the state vector, a probability distribution of acceleration values of the randomly selected scenario; and
randomly selecting (105), for the current time interval, an acceleration value based on the probability distribution of acceleration values of the randomly selected scenario.

3. The method according to any one of claims 1 to 2, wherein the driving cycle is generated by iteratively executing the steps (102, 103, 104, 105, 106, 107) of the method in the listed order and the predicted velocity values are each appended to the past velocity progression from a previous iteration.

4. The method according to any one of claims 1 to 3, wherein based on the past velocity progression for the same future time intervals a plurality of predicted velocity values are obtained, so that statistical velocity distributions are obtained for future time intervals.

5. The method according to any one of claims 1 to 4, wherein the state vector for a current time interval comprises at least one of the following components:
a current velocity value, one or more past velocity values, one or more acceleration values of one or more time intervals, one or more values of a change in acceleration of one or more time intervals, a value corresponding to a number of time intervals according to the duration of a currently ongoing acceleration maneuver, a value corresponding to a number of time intervals according to the duration of a currently ongoing deceleration maneuver, and a value corresponding to a number of time intervals according to the duration of a currently ongoing state of constant velocity.

6. The method according to any one of claims 1 to 5, wherein the acceleration value determined taking into account probabilities resulting from the acceleration prediction model and the state vector is based on the duration of a currently ongoing acceleration maneuver, a currently ongoing deceleration maneuver or a currently ongoing state of constant velocity.

7. The method according to any one of claims 1 to 6, wherein the current scenario of acceleration and/or the current scenario of deceleration and/or the current scenario of a state of constant velocity each have a probability distribution of acceleration values.

8. The method according to any one of claims 2 to 7, wherein an expected value of the probability distribution of acceleration values is set based on the past velocity progression.

9. The method according to any one of claims 1 to 8, wherein the acceleration prediction model is based on a statistical evaluation of measured driving data of at least one real vehicle, wherein preferably the measured driving data of the at least one real vehicle exclusively comprise a temporal sequence of velocity values.

10. Method for driving a vehicle by means of a system of adaptive driving control, in particular a driver assistance system, in particular for predictive driving functions, wherein the driving cycle of the vehicle driving ahead of the vehicle is determined by means of the method according to any one of claims 1 to 9.

11. The method according to claim 10, wherein based on the past velocity progression for the same future time intervals a plurality of predicted velocity values are obtained, so that statistical velocity distributions are obtained for future time intervals, wherein safety conditions for driving the vehicle are derived from the statistical velocity distributions.

12. A method of generating a driving cycle for a vehicle suitable for use by driver assistance systems, in particular for predictive driving functions, comprising the steps of any one of claims 1 to 9.

13. A method (200) for analyzing at least one component of a motor vehicle, wherein the at least one component or the motor vehicle is subjected to a real or simulated test operation based on at least one driving cycle which is determined by means of a method according to any one of claims 1 to 9.

14. A computer program product or computer-readable medium comprising instructions which, when executed by a computer, cause the computer to perform the steps of a method according to any one of claims 1 to 13.

15. A computer configured to perform the method steps according to any one of claims 1 to 13.

## Revendications

1. Procédé assisté par ordinateur (100) de génération d'un cycle de conduite pour un véhicule, lequel est adapté pour la simulation d'un mode de conduite, en particulier réel, **caractérisé en ce qu'**il comprend des étapes de travail suivantes :
de détermination (102) d'un vecteur d'état du cycle de conduite pour un intervalle de temps actuel à partir d'une courbe de vitesse passée ;
de fourniture d'un modèle de prédiction d'accélération ;
de définition (103, 104, 105) d'une valeur d'accélération en tenant compte de probabilités, qui résultent du modèle de prédiction d'accélération et du vecteur d'état ;
d'intégration de la valeur d'accélération définie (106) sur l'intervalle de temps actuel pour obtenir une valeur de vitesse prédite pour un intervalle de temps futur ; et
d'ajout (107) de la valeur de vitesse prédite à la courbe de vitesse du passé pour générer le cycle de conduite.

2. Procédé selon la revendication 1, dans lequel la définition (103, 104, 105) d'une valeur d'accélération en tenant compte de probabilités qui résultent du modèle de prédiction d'accélération et du vecteur d'état présente des étapes de travail supplémentaires suivantes :
de détermination (103), au moyen du modèle de prédiction d'accélération en fonction du vecteur d'état, d'une valeur de probabilité pour un scénario actuel d'accélération et une valeur de probabilité pour un scénario actuel de décélération et d'une valeur de probabilité pour un scénario actuel d'un état à vitesse constante ; et de sélection aléatoire (104), pour l'intervalle de temps actuel, d'un scénario d'accélération, de décélération ou de vitesse constante sur la base des valeurs de probabilité pour les scénariis actuels d'accélération, de décélération et de vitesse constante ; et/ou
de détermination, à l'aide du modèle de prédiction d'accélération en fonction du vecteur d'état, d'une distribution de probabilité de valeurs d'accélération du scénario sélectionné de manière aléatoire ; et
de sélection aléatoire (105), pour l'intervalle de temps actuel, d'une valeur d'accélération sur la base de la distribution de probabilité de valeurs d'accélération du scénario sélectionné de manière aléatoire.

3. Procédé selon l'une quelconque des revendications 1 à 2, dans lequel le cycle de conduite est généré par exécution itérative des étapes de travail (102, 103, 104, 105, 106, 107) du procédé dans l'ordre énuméré et les valeurs de vitesse prédites sont respectivement attachées à la courbe de vitesse passée à partir d'une itération précédente.

4. Procédé selon l'une quelconque des revendications 1 à 3, dans lequel, sur la base de la courbe de vitesse passée pour les mêmes intervalles de temps dans le futur, plusieurs valeurs de vitesse prédites sont respectivement obtenues de telle sorte que des distributions statistiques de vitesse sont obtenues pour les intervalles de temps dans le futur.

5. Procédé selon l'une quelconque des revendications 1 à 4, dans lequel le vecteur d'état pour un intervalle de temps actuel présente au moins un des composants suivants :
une valeur de vitesse actuelle, une ou plusieurs valeurs de vitesse passées, une ou plusieurs valeurs d'accélération d'un ou plusieurs intervalles de temps, une ou plusieurs valeurs d'une modification d'accélération d'un ou de plusieurs intervalles de temps, une valeur correspondant à un nombre d'intervalles de temps en fonction de la durée d'une manœuvre d'accélération en cours, une valeur correspondant à un nombre d'intervalles de temps correspondant à la durée d'une manœuvre de décélération en cours et une valeur correspondant à un nombre d'intervalles de temps correspondant à la durée d'un état à vitesse constante en cours.

6. Procédé selon l'une quelconque des revendications 1 à 5, dans lequel la valeur d'accélération définie en tenant compte de probabilités résultant du modèle de prédiction d'accélération et du vecteur d'état est basée sur la durée d'une manœuvre d'accélération en cours, d'une manœuvre de décélération en cours ou d'un état à vitesse constante en cours.

7. Procédé selon l'une quelconque des revendications 1 à 6, dans lequel le scénario actuel d'une accélération et/ou le scénario actuel d'une décélération et/ou le scénario actuel d'un état à vitesse constante présentent respectivement une distribution de probabilité de valeurs d'accélération.

8. Procédé selon l'une quelconque des revendications 2 à 7, dans lequel une valeur attendue de la distribution de probabilité de valeurs d'accélération est réglée sur la base de la courbe de vitesse passée.

9. Procédé selon l'une quelconque des revendications 1 à 8, dans lequel le modèle de prédiction d'accélération est basé sur une évaluation statistique de données de conduite mesurées d'au moins un véhicule réel, dans lequel les données de conduite mesurées d'au moins un véhicule réel présentent de préférence exclusivement une séquence temporelle de valeurs de vitesse.

10. Procédé de conduite d'un véhicule au moyen d'un système de régulation de conduite adaptative, en particulier d'un système d'assistance à la conduite, en particulier pour des fonctions de conduite prédictive, dans lequel le cycle de conduite du véhicule qui précède le véhicule est défini au moyen du procédé selon l'une quelconque des revendications 1 à 9.

11. Procédé selon la revendication 10, dans lequel, sur la base de la courbe de vitesse passée pour les mêmes intervalles de temps dans le futur, plusieurs valeurs de vitesse prédites sont obtenues de telle sorte que des distributions de vitesse statistiques sont obtenues pour les intervalles de temps dans le futur, dans lequel des conditions de sécurité pour la conduite du véhicule sont déduites des distributions de vitesse statistiques.

12. Procédé de génération d'un cycle de conduite pour un véhicule, qui est adapté pour être utilisé par des systèmes d'assistance à la conduite, en particulier pour des fonctions de conduite prédictives, et qui présente les étapes de travail de l'une des revendications 1 à 9.

13. Procédé (200) d'analyse d'au moins un composant d'un véhicule à moteur, dans lequel l'au moins un composant ou le véhicule à moteur est soumis à un fonctionnement d'essai réel ou simulé sur la base d'au moins un cycle de conduite qui est défini au moyen d'un procédé selon l'une quelconque des revendications 1 à 9.

14. Produit de programme d'ordinateur ou support lisible par ordinateur, qui présente des instructions qui, lorsqu'elles sont exécutées par un ordinateur, l'amènent à exécuter les étapes d'un procédé selon l'une quelconque des revendications 1 à 13.

15. Ordinateur qui est mis au point pour exécuter les étapes du procédé selon l'une quelconque des revendications 1 à 13.
